# EUROPEAN PATENT SPECIFICATION

(11) **EP 1 729 959 B1**
(45) Date of publication and mention of the grant of the patent: **02.11.2016**
(21) Application number: 05779119.6
(22) Date of filing: 11.01.2005
(51) Int. Cl.: C23C 28/00, C23C 28/04

(54) **DURABLE THERMAL BARRIER COATING HAVING LOW THERMAL CONDUCTIVITY**
WIDERSTANDSFÄHIGE WÄRMESPERRBESCHICHTUNG MIT GERINGER WÄRMELEITFÄHIGKEIT
REVÊTEMENT DE PROTECTION THERMIQUE LONGUE DURÉE À FAIBLE CONDUCTIVITÉ THERMIQUE

(30) Priority: 12.01.2004 US 756209; 03.05.2004 US 835667
(43) Date of publication of application: 13.12.2006
(73) Proprietor: CHROMALLOY GAS TURBINE CORPORATION, Orangeburg, NY 10962 (US)
(72) Inventor: LIU, Yourong, Hillsdale, NJ 07642 (US); LAWTON, Paul, Rock Hill, NY 12775 (US)
(74) Representative: Suèr, Steven Johannes
(86) International application number: PCT/US2005/000725
(87) International publication number: WO 2005/112603

(56) References cited:
- EP-A- 0 294 844
- EP-A- 0 825 271
- EP-A- 1 375 701
- US-A- 6 025 078
- J.R. NICHOLLS ET AL: "Methods to reduce the thermal conductivity of EB-PVD TBCs" SURFACE AND COATINGS TECHNOLOGY, vol. 151-152, 2002, pages 383-391, XP002543208
- KHOSHMAN ET AL: "Amorphous hafnium oxide thin films for antireflection optical coatings", SURFACE AND COATINGS TECHNOLOGY, ELSEVIER, AMSTERDAM, NL, vol. 202, no. 11, 11 February 2008 (2008-02-11), pages 2500-2502, XP022475460, ISSN: 0257-8972, DOI: 10.1016/J.SURFCOAT.2007.07.095
- ANONYMOUS: 'WebElements Periodic Table of the Elements | Hafnium | hafnium dioxide', [Online] 04 July 2014, XP055126870 Retrieved from the Internet: <URL:http://www.webelements.com/compounds/h afnium/hafnium_dioxide.html> [retrieved on 2014-07-04]

## Description

### FIELD OF THE INVENTION

The present invention relates generally to the field of thermal barrier coatings that are used in elevated temperature applications such as gas turbine engines. In particular, this invention relates to a thermal insulating ceramic coating, which has a low thermal conductivity as well as a long service life, and to the metallic articles such as turbine components, (e.g. blades and vanes) that the coatings are applied to prevent the components from overheating during high temperature operation.

### BACKGROUND OF THE INVENTION

Advanced gas turbine engines are continuously pursuing higher thrust and efficiency by the use of increased operating temperatures. However, the demand of increasing temperature is limited by the ability of most advanced nickel and cobalt based superalloy turbine blades and vanes to maintain their mechanical strength when exposed to the heat, oxidation, erosion and corrosion environment. Thus it is desirable to increase turbine engine operating temperatures, while decreasing the heat transfer to the metallic parts. One approach is to apply a thermal barrier coating onto the turbine blades and vanes to insulate the components from the high temperature operating environment. The ability of the thermal barrier coating to decrease the temperature to the metallic substrate depends upon the thermal conductivity of the thermal barrier coating. It is therefore desirable to develop thermal barrier coatings having low thermal conductivity to insulate effectively the thermal transfer to the components used in gas turbine engines, as well as providing a coated component having a long service life.

Efforts have been made to lower the thermal conductivity of thermal barrier coatings by modifying the chemistry and microstructure of current 7YSZ thermal barrier coating systems as disclosed in EP0816526A2, US Patent 6071628, US Patent 5846605, US Patent 6183884B1, US Patent 5792521, US Patent 5687679, WO1/63008 and US Patent 6284323B1. These approaches decreased thermal conductivity of thermal barrier coatings to various extents with the minimum reported to be about half the thermal conductivity of typical 7 wt% yttria stabilized zirconia (7YSZ).

An article by J R Nicholls et al. titled "Methods to reduce the thermal conductivity of EB-PVD TBCs" in Surface and Coatings Technology, vol. 151-152, 2002, pp 383-391 reported the examination of a number of alternative dopant additions to those previously reported by others (in relation to the addition of divalent transition metal oxides to zirconiaytrria TBCs) with the aim of further reducing the phonon thermal conductivity. Five dopant additions are disclosed: Erbia, nickel oxide, Neodymia, Gadolinia and Ytterbia. These ternary additions were introduced by custom manufacturing evaporation rods with known dopant levels, 2.0, 4.0 and 8.0 mol% and resulted in coating thicknesses between 120 and 400 *µ*m. The thermal conductivity of each doped TBC was measured. The data presented in this article is said to demonstrate the benefits of Erbia and Neodymia additions, at various mole fractions, where it is reported that up to 8 mol% results in a significant drop in thermal conductivity for both additions, with Neodymia more effective.

EP-A-0 825 271 discloses a metallic article which comprises a bond coating on the metallic article and a ceramic thermal barrier coating on the bond coating. The ceramic thermal barrier coating comprises zirconia stabilised with yttria, calcia, magnesia or india, and erbia to reduce the thermal conductivity of the ceramic thermal barrier coating. The ceramic thermal barrier coating is at least 100 microns thick. The erbium atom has an atomic mass greater than the average atomic mass of the zirconium, the yttrium, calcium, magnesium or indium and the oxygen atoms to reduce phonon thermal conductivity of the ceramic thermal barrier coating (18). The ceramic thermal barrier coating comprises 4 to 20wt% of yttria, 5 to 25wt% of erbia and the balance is zirconia plus incidental impurities. The erbia absorbs energy in the 0.3 microns to 5 microns waveband to reduce photon thermal conductivity. Other suitable additions besides erbia are said to be dysprosia, europia, gadolinia, praseodymia, urania or ytterbia.

EP-A-0 294 844 discloses a thermal barrier coating for a component comprising a substrate and a bond coat intended for use in a hostile environment, such as the superalloy turbine, combustor and augmenter components of a gas turbine engine. The coating material is zirconia that is partially stabilized with yttria and to which lanthana, neodymia and/or tantala are alloyed to increase the impact resistance of the coating.

It is a main object of the invention to decrease thermal conductivity of thermal barrier coatings by providing a new ceramic material with low thermal conductivity. This invention also provides a method of applying such a thermal barrier coating system onto the metallic parts providing increased thermal insulation capability and prolonged durability, as well as increased erosion resistance.

The present invention is as claimed in the claims.

### BRIEF DESCRIPTION OF THE DRAWINGS

Fig. 1 shows a ceramic coating, NdₓZr₁₋ₓO_{y} which was applied by EBPVD onto a metallic bond coat
Fig. 2 shows a ceramic coating, NdₓZr₁₋ₓO_{y} applied in a layered microstructure.
Figures 3(a) and 3(b) shows a protective ceramic top coat on the ceramic coating, NdₓZr₁₋ₓO_{y}.

### DETAILED DESCRIPTION OF THE INVENTION

This invention provides a thermal barrier ceramic coating having a formula of NdₓZr₁₋ₓO_{y} with yttria and hafnia added and dissolved in where 0<x <0.5, 1.75<y<2. The ceramic is formed by doping oxides of Nd and the selected metal oxides into a host zirconia ceramic forming a non-pyrochlore crystal structure. A preferred embodiment is where Z is yttria. The NdₓZr₁₋ₓO_{y} ceramic coating with yttria dissolved in can be prepared by doping 2 to 15 mole % of Nd₂O₃, preferably up to 7 moles %. The yttria level generally is from 2 to 14 mole %, preferably at least 6 wt % and the hafnium is generally at a level of from about 0.5 to 6 wt %, preferably 1.5 to 4 wt %. The ceramic coating of this invention is applied to a metallic article providing a thermal barrier coating with low thermal conductivity, resistance to erosion and high resistance to cyclic oxidation providing increased durability.

In one preferred embodiment the coating contains up to 7 mole % of neodymia, e.g. 2 to 7 mole %. The lower level of neodymia is believed to provide a coating with increased erosion resistance. Higher levels of rare earth oxides provide thermal barrier coatings which spall earlier in cyclic oxidational testing. An example is a coating with 7 mole % of Nd₂O₃ and 5 mole % Y₂O₃ (8 wt %).

In another preferred embodiment the coating has at least 6 wt % of yttria, preferably 6 to 10 wt %, optimally 6 to 8 wt % dissolved in. The higher level of yttria is believed to provide a further reduction in thermal conductivity due to higher concentration of oxygen vacancies in the matrix lattice structure, which will enhance phonon scattering. In addition, a phase transformation from high temperature to ambient temperature was found in the system of Nd-Zr without yttria or with low levels of yttria which could cause premature spallation of the coatings. The addition of at least 6 wt % of yttria avoids the premature spallation caused by phase transformation in the TBC system. Another benefit of doping at least 6 wt % Y₂O₃ is to increase the toughness of the ceramic coatings material. Cracks were found within the ceramic coating without yttria or with low levels of yttria (less than 6 wt %) under thermal cycle impact. The tougher ceramic coating containing at least 6 wt % yttria also provides good erosion resistance. Thus the addition of at least 6 wt % yttria to the ceramic coating provides a coating with lower thermal conductivity and greater durability due to its improved phase stability, increased toughness, erosion resistance and resistance to cyclic oxidation. One example is a coating with 10 mole % of Nd_{O3} and 6 wt % Y₂O₃ doped into ZrO₂. The further addition of hafnia along with yttria has the further advantage of reducing thermal conductivity and strengthening the ceramic material providing an increased resistance to erosion and thermal shock. An example is the further addition of about 3 wt % of hafnia (HfO₂) to the above example formulations

The ceramic coating of this invention has a low thermal conductivity generally within the range of about 0.78 to 1.02 W/mK from 600°C to 1100°C. This thermal conductivity is around 50% of the measured thermal conductivity of typical 7YSZ coating (1.65-2.22 W/mK from 600°C to 1100°C). In addition the ceramic coating of this invention has a high resistance to cyclic oxidation.

Techniques for applying the ceramic coatings, NdₓZr₁₋ₓO_{y} with yttria and hafnia dissolved in include air plasma thermal spray (APS), low pressure plasma spray (LPPS), high velocity oxygen fuel (HVOF), sputtering and electron beam physical vapor deposition (EBPVD), etc. In a preferred embodiment the ceramic coating is applied by electron beam physical vapor deposition (EBPVD) due to the columnar microstructure with inter-column gaps produced. The ceramic coating can be deposited as a straight columnar microstructure or a saw tooth microstructure or a layered microstructure or mix of thereof for further reduction in thermal conductivity. Generally, the ceramic coating is applied to a thickness within the range of about 5 to 500 µm, preferably about 25 to 400 µm. In a layered microstructure, the ceramic coating can have at least 2 layers, preferably from 5 to 100 layers, each at least about 1 µm thick, preferably about 5 to 25 µm thick.

The process of applying the ceramic coating by EBPVD is similar to that of applying 7YSZ in production. The evaporating source in a crucible is a solid ingot of the NdₓZr₁₋ₓO_{y} with Z dissolved in, which is sintered zirconia doped with neodymia and the selected metal oxide. The layered microstructure of the ceramic coating, NdₓZr₁₋ₓO_{y} with Z dissolved in, is applied by evaporating the solid ingots from two crucibles under controlled gun on/off program of electron beam physical vapor deposition. The ceramic coating, NdₓZr₁₋ₓO_{y} with yttria dissolved in, with 6-8wt% YSZ at the top is deposited by evaporating the solid ingot of NdₓZr₁₋ₓO_{y} with yttria and hafnia dissolved in from one crucible and 6-8wt% YSZ ingot from another crucible by electron beam physical vapor deposition.

For increased adhesion a metallic bond coat is applied onto the metallic article, such as a nickel or cobalt based superalloy prior to deposition of the ceramic coating. The metallic bond coat can be a MCrAlY alloy, wherein M is Ni, Co or mixtures thereof. Such alloys have a broad composition of 10 to 35% chromium, 5 to 15% aluminum, 0.01 to 1% yttrium, or hafnium, or lanthanum, with M being the balance. Minor amounts of other elements such as Ta or Si may also be present. The MCrAlY bond coat can be applied by EBPVD, though sputtering, low pressure plasma or high velocity oxy fuel spraying or entrapment plating may also be used.

Alternatively, the metallic bond coat can be comprised of an intermetallic aluminide such as nickel aluminide or platinum aluminide. The aluminide bond coating can be applied by standard commercially available aluminide processes whereby aluminum is reacted at the substrate surface to form an aluminum intermetallic compound, which provides a reservoir for the growth of an alumina scale oxidation resistant layer. Thus the aluminide coating is predominately composed of aluminum intermetallic [e.g., NiAl, CoAl and (Ni, Co) Al phase] formed by reacting aluminum vapor species, aluminum rich alloy powder or surface layer with the substrate elements in the outer layer of the superalloy component. This layer is typically well bonded to the substrate. Aluminizing may be accomplished by one of several conventional prior art techniques, such as, the pack cementation process, spraying, chemical vapor deposition, electrophoresis, sputtering, and appropriate diffusion heat treatments. Other beneficial elements can also be incorporated into diffusion aluminide coatings by a variety of processes. Beneficial elements include Pt, Pd, Si, Hf, Y and oxide particles, such as alumina, yttria, hafnia, for enhancement of alumina scale adhesion, Cr and Mn for hot corrosion resistance, Rh, Ta and Cb for diffusional stability and/or oxidation resistance and Ni, Co for increasing ductility or incipient melting limits. In the specific case of platinum modified diffusion aluminide coating layers, the coating phases adjacent to the alumina scale will be platinum aluminide and/or nickel-platinum aluminide phases (on a Ni-base superalloy).

Through oxidation an alumina (i.e., aluminum oxide) layer is formed over the metallic bond coat. This alumina layer provides both oxidation resistance and a bonding surface for a ceramic coating. The alumina layer may be formed before the ceramic coating is applied, during application of the coating or subsequently by heating the coated article in an oxygen containing atmosphere at a temperature consistent with the temperature capability of the superalloy, or by exposure to the turbine environment. The sub-micron thick alumina scale will thicken on the aluminide surface by heating the material to normal turbine exposure conditions. The thickness of the alumina scale is preferably sub-micron (up to about one micron). The alumina layer may also be deposited by chemical vapor deposition following deposition of the metallic bond coat.

Alternatively, the metallic bond coat may be eliminated if the substrate is capable of forming a highly adherent alumina scale or layer. Examples of such substrates are very low sulfur (<1 ppm) single crystal superalloys, such as PWA 1487 and Rene N5, which also contain 0.1% yttrium to enhance adhesion of the thermally grown alumina scale.

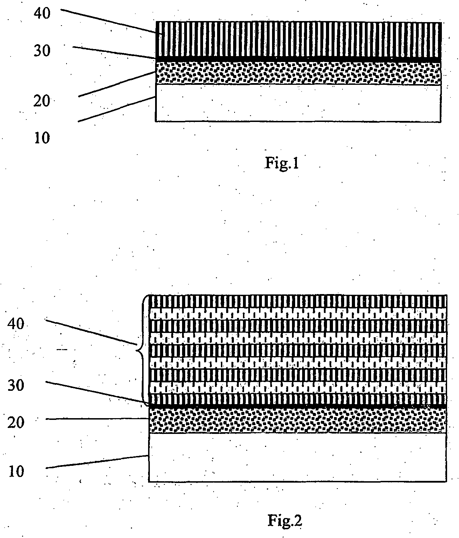

Fig. 1 shows the ceramic coating, NdₓZr₁₋ₓO_{y} with yttria and hafnia dissolved in, 40 which was applied by EBPVD onto a metallic bond coat **20,** such as a MCrAlY and/or platinum modified aluminide. The bond coat 20 was applied to the metallic article 10, of nickel or cobalt based superalloys prior to the application of the ceramic coating 40. The bond coat 20 provides strong adhesion between the metallic substrate 10 and the ceramic coating 40. The ceramic coating adheres to the bond coat 20 through a thermally grown alumina film 30 on the bond coat 20.

Figure 2 shows the ceramic coating, NdₓZr₁₋ₓO_{y} with yttria and hafnia dissolved in, 40 applied in a layered microstructure. The interface boundaries between the layers are another potential source of phonon scattering for thermal conductivity reduction.

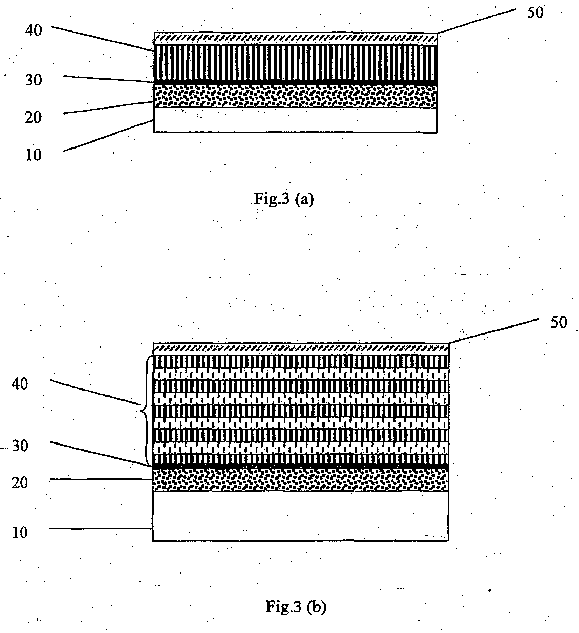

Figures 3(a) and 3(b) show a protective ceramic top coat 50 which is coated after the columnar ceramic coating NdₓZr₁₋ₓO_{y} with yttria and hafnia dissolved in 40, to provide increased erosion resistance on the top surface which is subject to hot gas impact during turbine engine operation. This protective ceramic top coat can be a dense and/or wide column of ceramic coating NdₓZr₁₋ₓO_{y} with yttria and hafnia dissolved in, or alternatively, layer 50 could also be 6-8wt% YSZ. This protective ceramic top coat, 50 for erosion resistance, generally has a thickness of about 5 to 50 µm preferably about 10 to 25 µm thick. A protective top coat of 7YSZ with an appropriate thickness for erosion resistance on the ceramic coating, NdₓZr₁₋ₓO_{y} with yttria and hafnia dissolved in, provides a thermal conductivity which is equivalent to the ceramic coating without the protective ceramic top coat.

The ceramic coating system of this invention provides many advantages for use in gas turbine engines. The reduction in thermal conductivity of 50 percent can reduce the thickness required for the thermal barrier coating (TBC) by approximately one half for the same degree of thermal insulation. This will lower the cost of the TBC due to the time saved in applying the coating, ingot material savings and energy savings in production. Decreasing in the coating thickness will also lower the weight of the gas turbine component, e.g. blades and vanes, which can provide a significant reduction in the weight of the disk that holds these components. Depositing the same thickness of the ceramic coating will allow an increased operating temperature to be achieved without overheating the metallic parts allowing the engine to operate a higher thrust and efficiency. The increased insulating capabilities of the ceramic coating could also reduce the requirements for air cooling the part.

This invention is generally applicable to any metallic article which uses thermal barrier coating system, and includes various modifications according to the principles of this invention.

## Claims

1. A metallic article comprising a metallic substrate and a thermal barrier ceramic coating on its surface wherein the ceramic coating is of formula NdₓZr₁₋ₓO_{y} wherein 0<x<0.5 and 1.75<y<2; comprises up to 7 mol % Nd₂O₃ and further comprises yttria and hafnia added and dissolved in.

2. The article of Claim 1, wherein with at least 6 wt% of yttria is added and dissolved in.

3. The article of Claim 2, with from 2 to 7 mol % of Nd₂0₃ and 6 to 10 wt % of yttria dissolved in and with 0.5 to 6 wt % hafnia added and dissolved in.

4. A metallic article comprising a metallic substrate and a thermal barrier ceramic coating on its surface, wherein the ceramic coating is of formula NdₓZr₁₋ₓO_{y} wherein 0< x<0.5 and 1.75 < y < 2, and wherein the ceramic coating has at least 6 wt % of yttria added and dissolved in and further has hafnia added and dissolved in.

5. An article of Claim 4, having 6 to 10 wt % of yttria dissolved in and 2 to 15 mole % Nd₂0₃ and with 0.5 to 6 wt % hafnia added and dissolved in

6. An article of Claims 1 or 4, with 1.5 to 4 wt % of hafnia is added and dissolved in.

7. An article of Claims 1 or 4, further comprising a metallic bond coat between the ceramic coating and the metallic substrate.

8. An article of Claim 7, wherein the ceramic coating has a columnar microstructure.

9. An article of Claim 7, wherein the columnar microstructure is a straight or a saw tooth structure.

10. An article of Claim 7, wherein the ceramic coating has a layered microstructure with interface boundaries between layers.

11. An article of Claim 7, further comprising a protective ceramic top coat overlaying the ceramic coating.

12. An article of Claim 11, wherein the protective ceramic top coat is the ceramic coating with a dense columnar microstructure.

13. An article of Claims 1 or 4, wherein the metallic article is a turbine component which has a metallic substrate of a nickel or cobalt based superalloy.

14. A method for applying a thermal barrier ceramic coating to a metallic article comprising:
forming a ceramic of formula NdₓZr₁₋ₓO_{y}, wherein 0<x<0.5 and 1.75 <y<2; with yttria and hafnia added and dissolved in; with at least 6 wt % of yttria added and dissolved in, by doping yttria, hafnia and neodymia into a zirconia ceramic; and
applying the ceramic as a coating onto the metallic article.

15. A method of Claim 14, wherein the ceramic is applied by electron beam physical vapor deposition.

16. A method of Claim 14, with 0.5 to 6 wt% hafnia added and dissolved into a zirconia ceramic.

## Patentansprüche

1. Metallartikel mit einem Metallsubstrat und einer auf dessen Oberfläche angeordneten Wärmebarriere-Keramikbeschichtung, wobei die Keramikbeschichtung die Formel NdₓZr₁₋ₓO_{y}, aufweist, wobei 0<x<0,5 und 1,75<y<2; mit bis zu 7 Mol-% Nd₂O₃ und ferner mit Yttriumoxid und Hafniumoxid, die dem Artikel hinzugefügt und darin aufgelöst sind.

2. Artikel nach Anspruch 1, mit mindestens 6 Gew.-% an Yttriumoxid, das dem Artikel hinzugefügt und darin aufgelöst ist.

3. Artikel nach Anspruch 2, mit 2 bis 7 Mol-% an Nd₂O₃ und 6 bis 10 Gew.-% an Yttriumoxid, das in dem Artikel aufgelöst ist, und mit 0,5 bis 6 Gew.-% an dem Artikel hinzugefügt und darin aufgelöst ist.

4. Metallartikel mit einem Metallsubstrat und einer auf dessen Oberfläche angeordneten Wärmebarriere-Keramikbeschichtung, wobei die Keramikbeschichtung die Formel NdₓZr₁₋ₓO_{y}, aufweist, wobei 0<x<0,5 und 1,75<y<2; und wobei die Keramikbeschichtung mindestens 6 Gew.-% an Yttriumoxid, das ihr hinzugefügt und darin aufgelöst ist, und ferner ihr hinzugefügt und darin aufgelöst ist.

5. Artikel nach Anspruch 4, mit 6 bis 10 Gew.-% an Yttriumoxid, das in dem Artikel aufgelöst ist, und 2 bis 15 Mol-% an Nd₂O₃ und mit 0,5 bis 6 Gew.-% an dem Artikel hinzugefügt und darin aufgelöst sind.

6. Artikel nach Anspruch 1 oder 4, mit 1,5 bis 4 Gew.-% an dem Artikel hinzugefügt und darin aufgelöst ist.

7. Artikel nach Anspruch 1 oder 4, ferner mit einer metallischen Verbindungsschicht zwischen der Keramikbeschichtung und dem Metallsubstrat.

8. Artikel nach Anspruch 7, bei dem die Keramikbeschichtung eine säulenartige Mikrostruktur hat.

9. Artikel nach Anspruch 7, bei dem die säulenartige Mikrostruktur eine geradlinige oder sägezahnartige Struktur ist.

10. Artikel nach Anspruch 7, bei dem die Keramikbeschichtung eine geschichtete Mikrostruktur mit Grenzflächen zwischen den Schichten hat.

11. Artikel nach Anspruch 7, ferner mit einer schützenden keramischen Oberbeschichtung, die über der Keramikbeschichtung angeordnet ist.

12. Artikel nach Anspruch 11, bei der die schützende keramische Oberbeschichtung die Keramikbeschichtung mit einer dichten säulenartigen Mikrostruktur ist.

13. Artikel nach Anspruch 1 oder 4, wobei der Metallartikel eine Turbinenkomponente ist, die ein Metallsubstrat einer nickel- oder kobaltbasierten Superlegierung aufweist.

14. Verfahren zum Aufbringen einer Wärmebarriere-Keramikbeschichtung auf einen Metallartikel, umfassend:
Bilden einer Keramik mit der Formel NdₓZr₁₋ₓO_{y}, wobei 0<x<0,5 und 1,75<y<2; mit Yttriumoxid und Hafniumoxid, die der Keramik hinzugefügt und darin aufgelöst sind; mit mindestens 6 Gew.-% an Yttriumoxid, das dem Keramik hinzugefügt und darin aufgelöst ist, indem Yttriumoxid, Hafniumoxid und Neodymoxid zu ZirkoniumoxidKeramik dotiert sind; und
Aufbringen der Keramik als Beschichtung auf den Metallartikel.

15. Verfahren nach Anspruch 14, bei dem die Keramik mittels durch physikalischen Elektronenstrahl erfolgenden Dampfauftrags aufgetragen wird.

16. Verfahren nach Anspruch 14, mit 0,5 bis 6 Gew.-% an einer Zirkoniumoxid-Keramik hinzugefügt und darin aufgelöst wird.

## Revendications

1. Article métallique comprenant un substrat métallique et un revêtement céramique de protection thermique sur sa surface, dans lequel le revêtement céramique a pour formule NdₓZr₁₋ₓO_{y} où 0 < x < 0,5 et 1,75 < y < 2 ; comprend jusqu'à 7 % mol Nd₂0₃ et comprend en outre de l'yttria et du hafnia ajoutés et dissous.

2. Article selon la revendication 1, dans lequel au moins 6% en poids d'yttria est ajouté et dissous.

3. Article selon la revendication 2, dans lequel de 2 à 7 % mol de Nd₂0₃ et 6 à 10 % en poids d'yttria est dissous et avec 0,5 à 6% en poids de hafnia ajouté et dissous.

4. Article métallique comprenant un substrat métallique et un revêtement céramique de protection thermique sur sa surface, dans lequel le revêtement céramique est de formule NdₓZr₁₋ₓO_{y} où 0 < x<0,5 et 1,75 < y < 2, et dans lequel le revêtement céramique a au moins 6% en poids d'yttria ajouté et dissous et contient en outre du hafnia ajouté et dissous.

5. Article selon la revendication 4, ayant de 6 à 10% en poids d'yttria dissous et de 2 à 15 % mol de Nd₂0₃ et de 0,5 à 6% en poids de hafnia ajouté et dissous.

6. Article selon les revendications 1 ou 4, avec 1,5 à 4% en poids de hafnia ajouté et dissous.

7. Article selon les revendications 1 ou 4, comprenant en outre un revêtement de liaison métallique entre le revêtement céramique et le substrat métallique.

8. Article selon la revendication 7, dans lequel le revêtement céramique a une microstructure colonnaire.

9. Article selon la revendication 7, dans lequel la microstructure colonnaire est une structure droite ou à dentition en scie.

10. Article selon la revendication 7, dans lequel le revêtement céramique a une microstructure à couches avec des limites d'interface entre couches.

11. Article selon la revendication 7, comprenant en outre un revêtement céramique supérieur protecteur sur le revêtement céramique.

12. Article selon la revendication 11, dans lequel le revêtement céramique supérieur protecteur est le revêtement céramique avec une microstructure colonnaire dense.

13. Article selon les revendications 1 ou 4, dans lequel l'article métallique est un composant de turbine qui a un substrat métallique en superalliage de nickel ou de cobalt.

14. Procédé pour appliquer un revêtement céramique de protection thermique sur un article métallique, comprenant :
la formation d'une céramique de formule NdₓZr₁₋ₓO_{y}, où 0<x < 0,5 et 1,75 < y < 2 ; l'yttria et le hafnia étant ajoutés et dissous ; avec au moins 6% en poids d'yttria ajouté et dissous, en dopant de l'yttria, du hafnia et du néodymia dans une céramique zirconium ; et
l'application de la céramique comme revêtement sur l'article métallique.

15. Procédé selon la revendication 14, dans lequel la céramique est appliquée par dépôt de vapeur physique sous faisceau d'électrons.

16. Méthode selon la revendication 14 avec 0,5 à 6% en poids de hafnia ajouté et dissous dans une céramique zirconium.
